(19) **Europäisches Patentamt / European Patent Office / Office européen des brevets**

(11) **EP 2 521 268 B1**

(12) **EUROPEAN PATENT SPECIFICATION**

(45) Date of publication and mention
of the grant of the patent:
**16.09.2015 Bulletin 2015/38**

(51) Int Cl.:
*H03M 1/12* (2006.01)     *H03M 1/66* (2006.01)
*H03M 1/06* (2006.01)

(21) Application number: **11164024.9**

(22) Date of filing: **28.04.2011**

(54) **Data converter system that avoids interleave images and distortion products**

Datenkonverter zur Vermeidung von Bildüberlappung und Verzerrungsprodukten

Système convertisseur de données qui éviter les images entrelacées et les produits de distorsion

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.11.2012 Bulletin 2012/45**

(73) Proprietor: **Tektronix, Inc.**
**Beaverton, Oregon 97077-0001 (US)**

(72) Inventor: **Sheppard, Roger D.**
**Portland, OR 97219 (US)**

(74) Representative: **Clarke, Jeffrey David et al**
**HGF Limited**
**Fountain Precinct**
**Balm Green**
**Sheffield S1 2JA (GB)**

(56) References cited:
EP-A2- 1 336 855     US-A1- 2007 081 578
US-B1- 6 473 013     US-B1- 6 507 624
US-B1- 7 196 650     US-B2- 6 744 832
US-B2- 7 483 498

- POBEREZHSKIY Y ET AL: "Sampling and signal reconstruction structures performing internal antialiasing filtering", ELECTRONICS, CIRCUITS AND SYSTEMS, 2002. 9TH INTERNATIONAL CONFERENCE ON SEP. 15-18, 2002, PISCATAWAY, NJ, USA,IEEE, vol. 1, 15 September 2002 (2002-09-15), pages 21-24, XP010611711, ISBN: 978-0-7803-7596-3
- BRAD BRANNON: "Wideband radios need wide dynamic range converters", INTERNET CITATION, 4 January 2002 (2002-01-04), XP002458026, Retrieved from the Internet: URL: http://web.archive.org/web/20020104143 710/http://www.analog.com/library/analogDi alogue/archives/29-2/wdbnradios.html [retrieved on 2007-11-08]
- BRANNON B: "USING WIDE DYNAMIC RANGE CONVERTERS FOR WIDE BAND RADIOS", RF DESIGN, PRIMEDIA BUSINESS MAGAZINES & MEDIA, OVERLAND PARK, KS, US, vol. 18, no. 5, 1 May 1995 (1995-05-01), pages 50/51,54,63-65, XP000505468, ISSN: 0163-321X

EP 2 521 268 B1

## Description

FIELD OF THE INVENTION

The present invention relates to data converters, and more particularly to a data converter system that avoids interleave images and distortion products.

BACKGROUND OF THE INVENTION

Data converters such as analog-to-digital converters (ADCs), digital-to-analog converters (DACs), and track-and-holds (T/Hs) can be used in two different ways. The first way is as a "baseband data converter" in which the data converter samples at a sample rate ("Fs") that is at least twice as high as the highest frequency contained in an input signal. In order to prevent aliasing, the input frequencies must be restricted to the frequency range spanning DC to Fs/2, or in other words, the input frequencies must be "confined" to the first "Nyquist zone," where the first Nyquist zone is the frequency range spanning DC to Fs/2, the second Nyquist zone is the frequency range spanning Fs/2 to Fs, the third Nyquist zone is the frequency range spanning Fs to 3Fs/2, and so on. The second way that a data converter may be used is as a "band-pass data converter" in which input frequencies are confined to one of the higher Nyquist zones. Although the input frequencies are technically aliased, a band-pass data converter can provide high fidelity from any Nyquist zone so long as the data converter has sufficient analog bandwidth and it is protected with an anti-aliasing filter, if necessary to prevent signals in other Nyquist zones from aliasing into the Nyquist zone of interest and corrupting the input signal. The following discussion pertains to band-pass data converters.

Spurious free dynamic range (SFDR) is defined as the ratio of the root-mean-square (RMS) value of the maximum signal component at the input of a data converter to the RMS value of the largest spurious component at its output. SFDR is a very important specification for test and measurement instruments that use T/Hs and ADCs to digitize analog signals such as spectrum analyzers, oscilloscopes, and network analyzers, as well as for test and measurement instruments that use DACs to generate analog signals such as vector signal generators and arbitrary waveform generators.

Data converters can impair SFDR by introducing various types of spurious tones. First, data converters can introduce residual tones that are related to system clocks, data patterns, or other signals used in the system. Second, two or more data converters may be interleaved to provide the equivalent of a single data converter having a higher effective sample rate (Fs'), however interleaved data converters also produce undesired spectral components referred to as "interleave images" due to mismatches between the individual data converters. Third, data converters can introduce harmonic and intermodulation distortion products.

There are many techniques to reduce these spurious tones to acceptable levels. In some applications these techniques are acceptable, however in others they are prohibitively expensive or resource intensive. US 7,196,650 discloses a signal converter system with enhanced signal-to-noise ratio. US 6473013 discloses a parallel processing analog and digital converter. EP 1 336 855 A2 discloses an apparatus for detecting electromagnetic interferences. US 6,744,832 discloses analog-to-digital converter bank based ultra wide band communications. US 6,507,624 discloses a bandpass sampling architecture for wide-frequency band signal analysis. US 7,483,498 discloses frequency content separation using complex frequency shifting converters. Ye. Poberezhskiy and G. Poberezhskiy disclose sampling and signal reconstruction structures performing internal antialiasing filtering, IEEE, 2002. US 2007/0081578 A1 discloses Nyquist folded bandpass sampling receivers with narrow band filters for UWB pulses.

Document "Wideband Radios Need Wide Dynamic Range Converters" (Brad Brannon; Analog Dialogue 4 Jan 2002) discloses important considerations for A/D converters in wideband receivers.

Document "Using Wide Dynamic Range Converters for Wide Band Radios" (Brad Brannon; RF Design 18(1995)May, No.5) discloses improvements in radio architectures using A/D Converters and includes considerations for selection of A/D converters in radio designs.

What is desired is a data converter having reduced spurious tones.

SUMMARY OF THE INVENTION

Accordingly, the invention proposes a data converter system according to claim 1. Further embodiments are set out according to the dependent claims. The embodiments of the present invention provide a data converter system that confines an input signal to a specified frequency band and over-samples so that the converted input signal "straddles" or "avoids" spurious tones. The spurious tones may then be filtered away, providing an output signal having a much cleaner SFDR than a conventional data converter. For example, in one embodiment, an interleaved data converter system converts an input signal that is confined to the second Nyquist zone of one of the interleaved data converters into an interleaved signal, and then filters the interleaved signal with a filter having a pass-band that transmits the converted input frequencies and a stop-band that attenuates the spurious tones. The resulting output signal has a bandwidth that is the same as could be achieved using a single data converter, but is not impaired by interleave images or certain distortion products.

The objects, advantages and other novel features of the present invention are apparent from the following detailed description when read in conjunction with the appended claims and attached drawing.

BRIEF DESCRIPTION OF THE DRAWINGS

Figure 1 depicts a high-level block diagram of a four-way interleaved analog-to-digital converter system according to an embodiment of the present invention.

Figure 2 illustrates the locations of interleave images and distortion products in a frequency spectrum of an interleaved digital signal produced using the four-way interleaved analog-to-digital converter system of Figure 1.

Figure 3 depicts a high-level block diagram of a four-way interleaved digital-to-analog converter system according to an embodiment of the present invention.

Figure 4 depicts a high-level block diagram of a four-way interleaved track-and-hold system according to an embodiment of the present invention.

Figure 5 depicts a high-level block diagram of a non-interleaved analog-to-digital converter system according to an embodiment of the present invention.

DETAILED DESCRIPTION OF THE INVENTION

As was mentioned above, two or more data converters may be interleaved to provide the equivalent of a single data converter having a higher effective sample rate, however interleaved data converters also produce interleave images due to mismatches between the individual data converters. Now, in more detail, DC offset error in a single data converter results in an error term located at DC. In an interleaved system, DC offset mismatch between the interleaved data converters results in interleave images that are located at the base sample rate of a single data converter and multiples of that frequency.

Accordingly, in one embodiment of the present invention, an interleaved data converter system avoids interleave images due to DC offset mismatch by confining an input signal so that it does not fall at DC, the base sample rate of one of the data converters used in the interleaved system, or multiples of that frequency, so that the converted input frequencies "straddle" or "avoid" the spurious tones. The spurious tones may then be filtered away, providing an output signal having a much cleaner SFDR than a conventional data converter.

Input gain and phase mismatch and sample clock timing mismatch between interleaved data converters create tones located in other Nyquist zones. If the data converters are perfectly matched, then these tones are of equal amplitude but out of phase with respect to each other and thus cancel completely. However, if the matching is not perfect, then the tones will not cancel completely, leaving residual interleave images.

Accordingly, in another embodiment of the present invention, an interleaved data converter system avoids interleave images due to input gain and phase mismatch and sample clock timing mismatch by confining an input signal to a Nyquist zone of a single data converter used in the interleaved system, so that the converted input frequencies "straddle" or "avoid" the spurious tones. The spurious tones may then be filtered away, providing an output signal having a much cleaner SFDR than a conventional data converter.

Harmonic distortion products are located at multiples of the input frequency. For example, the second and third harmonic products of a 10 MHz signal fall at 20 MHz and 30 MHz respectively. In order to determine how a data converter may avoid harmonic distortion products, consider the following: If an input signal is confined to the first Nyquist zone of a data converter, then the second harmonic distortion product will generally fall within that same band. For example, suppose that a data converter samples at 100 Mega-Samples per second (MSa/s) so that the first Nyquist zone is the frequency range spanning DC to 50 MHz. If that data converter samples a 10 MHz input signal, then the second harmonic distortion product will fall at 20 MHz, which is still in the first Nyquist zone. However, if the input signal is confined to the second Nyquist zone, then the second harmonic distortion product will fall in the third Nyquist zone. For example, if that same data converter samples a 60 MHz input signal, then the second harmonic distortion product will fall at 120 MHz which is the third Nyquist zone. Thus, it is advantageous for the data converter to operate in the second Nyquist zone only. Mathematically, this can be expressed by the requirement that the frequencies at the low end of the band containing the input signal ("Fl") must be greater than or equal to one half of the frequencies at the high end of that band ("Fh"):

$$Fl > Fh/2 \qquad \text{(Equation 1)}$$

A second requirement is that the second harmonic distortion products must not alias right back into the band containing the input signal. Aliasing occurs for the range Fs-Fh to Fs-Fl. To keep second harmonic distortion out of this band requires that:

$$2 \times Fh \leq Fs - Fh \qquad \text{(Equation 2)}$$

Adding Fh to both sides of Equation 2 and then dividing both sides by three yields:

$$Fh \leq Fs/3 \qquad \text{(Equation 3)}$$

Plugging Equation 3 into Equation 1 yields:

$$Fl > ((Fs/3)/2), \text{ i.e. } Fl > Fs/6 \qquad \text{(Equation 4)}$$

Thus, in another embodiment of the present invention, a data converter may avoid second harmonic distortion products by confining the input signal to frequencies between Fs/6 and Fs/3, a frequency band having a width of Fs/6 or 16.66% of Fs. The data converter may be a single data converter or a plurality of interleaved data converters (in which case Fs becomes Fs', the effective sample rate of the interleaved system). If the data converter is a three-way interleaved data converter system, then this frequency band is equivalent to the second Nyquist zone of one of the interleaved data converters, and thus the three-way interleaved data converter system also avoids interleave images as discussed above.
This principle is not limited to avoiding second harmonic distortion products, but may be used to avoid harmonic distortion products of any degree. For example, in order to determine how a data converter may avoid third harmonic distortion products, one may rewrite Equation 2 by replacing the "2" with "3" as follows:

$$3 \times Fh \leq Fs - Fh \qquad \text{(Equation 5)}$$

Solving Equations 5 and 1 as described above, one finds that a data converter may avoid third harmonic distortion products by confining the input signal to frequencies between Fs/8 and Fs/4, a frequency band having a width of Fs/8 or 12.5% of Fs. The data converter may be a single data converter or a plurality of interleaved data converters (in which case Fs becomes Fs', the effective sample rate of the interleaved system). If the data converter is a four-way interleaved data converter system, then this frequency band is equivalent to the second Nyquist zone of one of the interleaved data converters, and thus the four-way interleaved data converter system also avoids interleave images as discussed above.
Generalizing the above results, a data converter may avoid harmonic distortion products of degree n, where n is an integer greater than or equal to two, by confining an input signal to a frequency band spanning $Fs/(2 \times (n+1))$ to $Fs/(n+1)$ and then attenuating the remaining Nyquist zones to eliminate the spurious tones. The higher the degree of interleaving and over-sampling that is used, the higher the degree of the harmonic distortion that may be avoided, with the trade-off being that less of the available bandwidth is used. The data converter may be a single data converter or a plurality of interleaved data converters (in which case Fs becomes Fs', the effective sample rate of the interleaved system). If the data converter is an (n+1)-way interleaved data converter system, the frequency band spanning $Fs'/(2 \times (n+1))$ to $Fs'/(n+1)$ is equivalent to the second Nyquist zone of one of the interleaved data converters, and thus the interleaved data converter system also avoids interleave images as discussed above.
According to an exemplary embodiment, the data converter system further includes the data converter comprising n+1 interleaved data converters for converting the input signal into n+1 interleaved signals, and means for combining the n+1 interleaved signals into the converted signal; and the specified frequency band comprises a frequency band spanning $Fs'/(2 \times (n+1))$ to $Fs'/(n+1)$, where Fs' is the effective sample rate of the plurality of interleaved data converters, the specified frequency band also comprising a second Nyquist zone of one of the interleaved data converters, so that the spurious tones comprising interleave images and harmonic distortion products of degree n, where n is an integer greater than or equal to two, are eliminated.

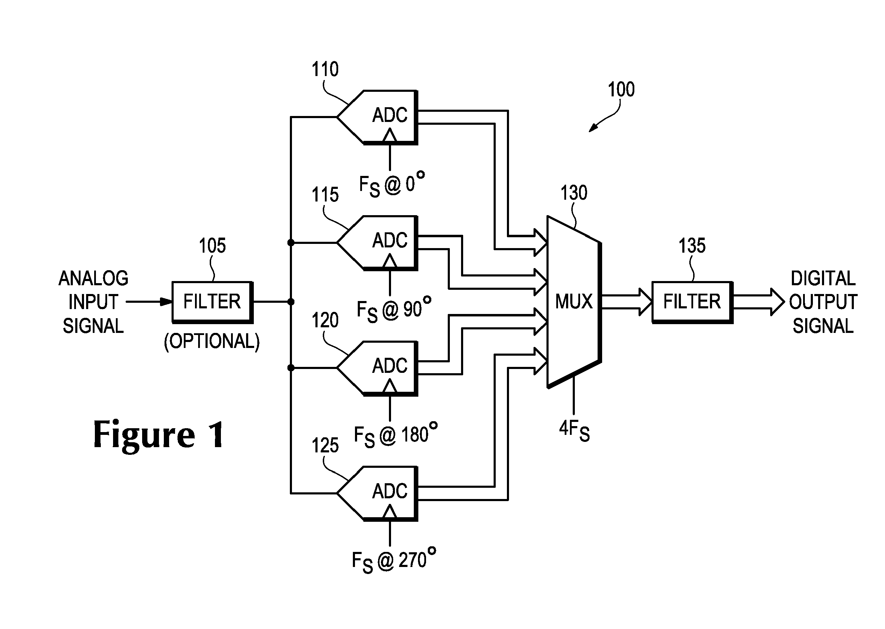

In accordance with the principles discussed above, Figure 1 illustrates a four-way interleaved data converter system **100** according to an embodiment of the present invention. The four-way interleaved data converter system **100** receives an analog input signal that is confined to a specified frequency band. If necessary to prevent aliasing, an optional anti-aliasing filter **105** filters the analog input signal to produce a filtered analog signal. Four interleaved ADCs **110**, **115**, **120**, and **125** convert the filtered analog signal into four converted signals. The four interleaved ADCs are clocked by four phases (nominally 0°, 90°, 180°, and 270°) of a sample clock so that each ADC samples at a base sample rate of Fs, where Fs is any sampling frequency that is supported by the ADC. A multiplexer **130** combines the four converted signals to form an interleaved digital signal having an effective sample rate of 4Fs or Fs'. In some embodiments, the multiplexer **130** may be implemented as a hardware multiplexer or serializer. In other embodiments, the four converted signals may be stored in memories and then multiplexed using software. A digital filter **135** having a pass-band that is substantially equivalent to the specified frequency band filters the interleaved digital signal to produce a digital output signal having reduced distortion products and interleave images. In various embodiments, the digital filter **135** may be implemented as a hardware filter (that is, using a digital signal processor, a field programmable gate array, or the like) or a software filter.

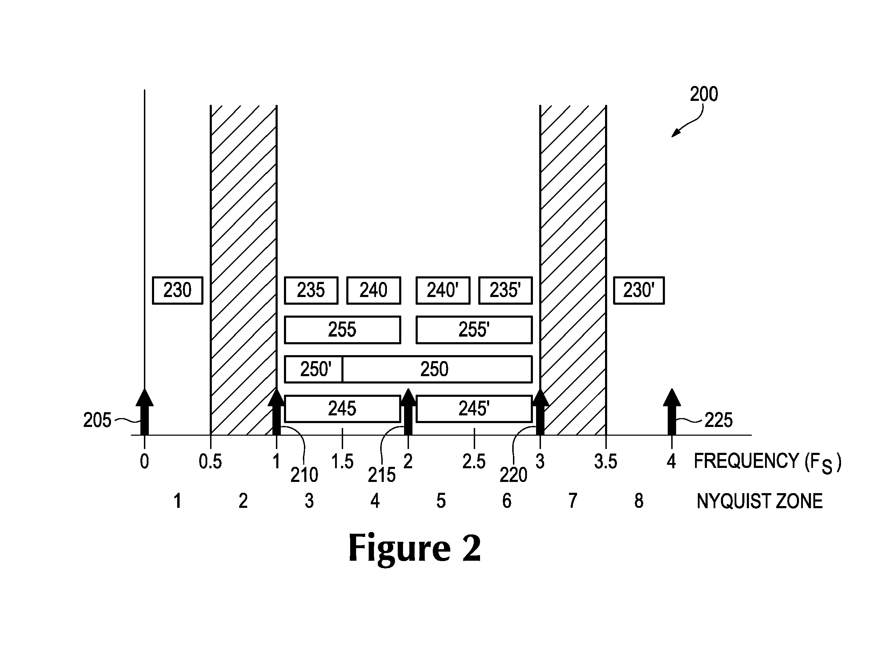

In operation, if the specified frequency band is the second Nyquist zone of one of the four interleaved ADCs, that is, Fs/2 to Fs, then the interleave images and distortion products produced by the four interleaved ADCs will appear in the spectrum of the interleaved digital signal at the locations shown in Figure 2. Since the four-way interleaved data converter system **100** samples at an effective sample rate of 4Fs or Fs', the interleave images and distortion products are aliased and mirror imaged about the effective Nyquist frequency of 2Fs or Fs'/2. Furthermore, the entire band between DC and 4Fs also repeats every 4Fs above 4Fs and below DC. For simplicity, these images are not shown or discussed. The Nyquist zones for each of the four interleaved ADCs are indicated on the horizontal axis. Since each of the four interleaved ADCs samples at a base sample rate of Fs, the first Nyquist zone is the frequency range spanning DC to Fs/2, the second Nyquist zone is the frequency range spanning Fs/2 to Fs, and so on.

DC offset error in one or more of the four interleaved ADCs results in an error term **205** located at DC. DC offset mismatch between the four interleaved ADCs results in interleave images **210**, **215**, **220**, and **225** that are located at the base sample rate of a single ADC (Fs) and multiples of that frequency (2Fs, 3Fs, and 4Fs), but they do not fall in the second Nyquist zone or its image in the seventh Nyquist zone.

Input gain and phase mismatch and sample clock timing mismatch between the four interleaved ADCs result in interleave images **230**, **235**, and **240** that fall in first, third, and fourth Nyquist zones and interleave images **230'**, **235'**, and **240'** that alias into the eighth, sixth, and fifth Nyquist zones, but again, they do not fall in the second or seventh Nyquist zones. These interleave images move as the input frequency moves, and thus they are depicted as bands that illustrate their possible locations.

Second harmonic distortion products **245** fall in the third and fourth Nyquist zones and alias **245'** into the fifth and sixth Nyquist zones, but do not fall in the second or seventh Nyquist zones. Third harmonic distortion products **250** fall in the fourth, fifth, and sixth Nyquist zones and alias **250'** into the third, fourth, and fifth Nyquist zones, but do not fall in the second or seventh Nyquist zones. As discussed above, the only harmonic distortion products that do fall in the second or seventh Nyquist zones are the fourth-order and higher products (not shown).

When two-tone signals Fin1 and Fin2 are applied, the primary intermodulation distortion products **255** produced are 2 × Fin1, 2 × Fin2, and Fin1 + Fin2, which fall in the third and fourth Nyquist zones and alias **255'** into the fifth and sixth Nyquist zones, but again, do not fall into the second or seventh Nyquist zones. The only intermodulation distortion products that do fall in the second or seventh Nyquist zones are the close-in products located at 2 × Fin1 - Fin2 and 2 × Fin2 - Fin1 (not shown).

In summary, because the four-way interleaved data converter system **100** confines the analog input signal to the second Nyquist zone of a single data converter and over-samples by a factor of four, the converted input signal falls in the second Nyquist zone of a single data converter and its images while the spurious tones fall in the first, third, and fourth Nyquist zones and their images. In other words, the converted input signal "straddles" or "avoids" the spurious tones. The spurious tones may then be filtered away, providing an output signal having a much cleaner SFDR than conventional data converter systems.

Since the purpose of the digital filter **135** is to transmit the specified frequency band and to attenuate the remaining Nyquist zones, it will be appreciated that the digital filter **135** is preferably a so-called "brick-wall" filter, that is, a filter that provides full transmission in a pass band, complete attenuation in a stop band, and infinitely abrupt transitions between the two. However, brick-wall filters are physically unrealizable in many applications. Thus, in other embodiments the digital filter **135** may be any type of filter that substantially transmits the specified frequency band and substantially attenuates the remaining Nyquist zones. In some embodiments, the digital filter **135** may be implemented as a band-pass filter having a pass-band that is substantially equivalent to the specified frequency band. In other embodiments, the converted input frequencies may be translated from the specified frequency band to other frequency locations before they are filtered, in which case the pass-band of the digital filter **135** must also be translated accordingly. For example, the converted input frequencies may be down-converted from the second Nyquist zone to base-band using a mixer, oscillator, and filter (not shown), in which case the digital filter **135** may be implemented as a low-pass filter.

Although the embodiments of the present invention described above confine the analog input signal to the second Nyquist zone of a single data converter, it will be recognized that the analog input signal may also be confined to any other Nyquist zone which is an image of the second Nyquist zone such as the seventh, tenth, or fifteenth Nyquist zones, provided that the interleaved data converters have sufficient analog bandwidth in that Nyquist zone and they are protected with an anti-aliasing filter, if necessary.

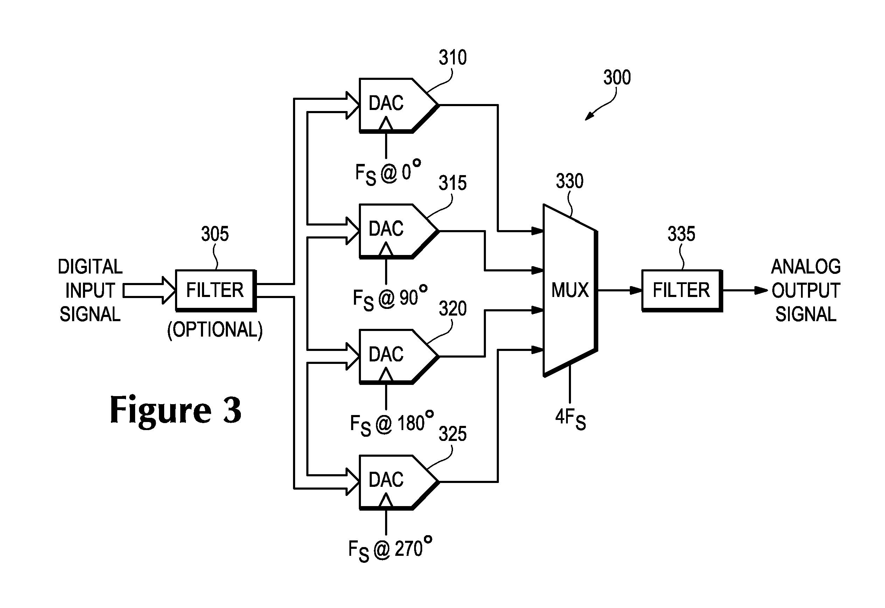

Although the embodiments of the present invention described above use ADCs, it will be appreciated that the principles described herein are equally applicable to systems that use other kinds of data converters. For example, as shown in Figure 3, a four-way interleaved data converter system **300** according to an embodiment of the present invention receives a digital input signal that is confined to a specified frequency band. If necessary to prevent aliasing, an optional anti-aliasing filter **305** filters the digital input signal to produce a filtered digital signal. Four interleaved DACs **310**, **315**, **320**, and **325** convert the filtered digital signal into four converted signals. The four interleaved DACs are clocked by four phases (nominally 0°, 90°, 180°, and 270°) of a sample clock so that each DAC samples at a base sample rate of Fs, where Fs is any sampling frequency that is supported by the DAC. A multiplexer **330** combines the four converted signals to form an interleaved analog signal having an effective sample rate of 4Fs or Fs'. In various embodiments, the multiplexer **330** may be implemented as an analog multiplexer, a matched broadband power combiner, or any other circuit suitable for combining analog signals. An analog filter **335** referred to as "reconstruction filter" having a pass-band that is substantially equivalent to the specified frequency band filters the interleaved analog signal to produce an analog output signal. If the specified frequency band is the second Nyquist zone of one of the four interleaved DACs, that is, Fs/2 to Fs, then the analog output signal will have reduced distortion products and interleave images.

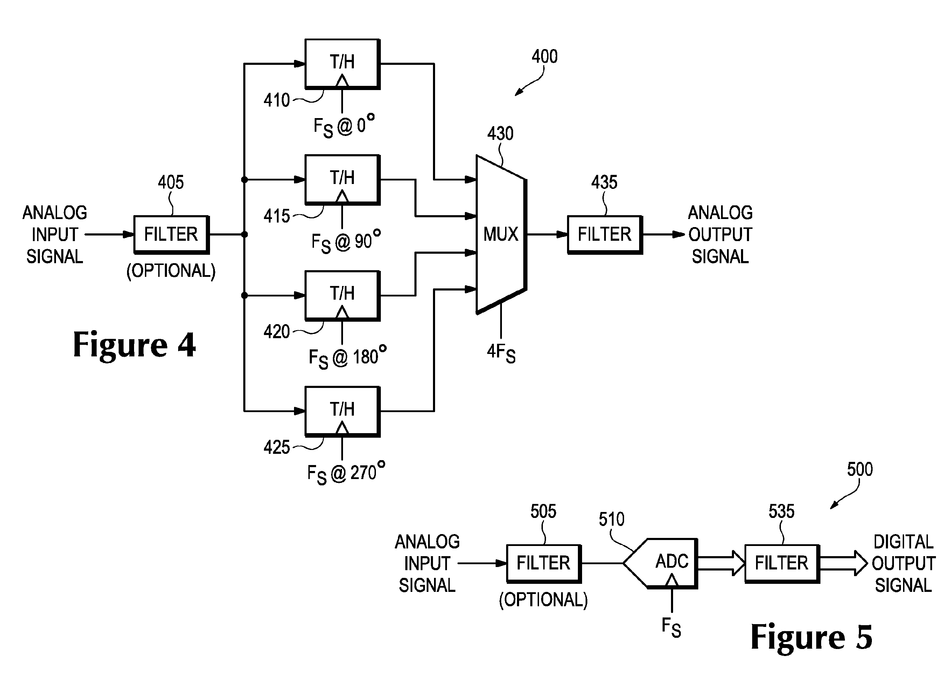

In another example shown in Figure 4, a four-way interleaved data converter system **400** according to an embodiment of the present invention receives an analog input signal that is confined to a specified frequency band. If necessary to prevent aliasing, an optional anti-aliasing filter **405** filters the analog input signal to produce a filtered analog signal. Four interleaved T/Hs **410**, **415**, **420**, and **425** convert the filtered analog signal into four converted signals. In various embodiments, each of the four interleaved T/Hs may be a zero-order-hold T/H, a return-to-zero (RZ) T/H, a non-return-to-zero (NRZ) T/H, a higher-order function T/H, a sampler, or the like. The four interleaved T/Hs are clocked by four phases (nominally 0°, 90°, 180°, and 270°) of a sample clock so that each T/H samples at a base sample rate of Fs, where Fs is any sampling frequency that is supported by the T/H. A multiplexer **430** combines the four converted signals to form an interleaved analog signal having an effective sample rate of 4Fs or Fs'. In various embodiments, the multiplexer **430** may be implemented as an analog multiplexer, a matched broadband power combiner, or any other circuit suitable for combining analog signals. An analog filter **435** having a pass-band that is substantially equivalent to the specified frequency band filters the interleaved analog signal to produce an analog output signal. If the specified frequency band is the second Nyquist zone of one of the four interleaved T/Hs, that is, Fs/2 to Fs, then the analog output signal will have reduced distortion products and interleave images.

Although the embodiments of the present invention illustrated in Figures 1, 3, and 4 avoid both interleave images and distortion products, it will be appreciated that other embodiments may avoid only interleave images, or only distortion products, by using different specified frequency bands. Furthermore, although the embodiments of the present invention illustrated in Figures 1, 3, and 4 use interleaved data converters, it will be appreciated that some of the embodiments that avoid only distortion products may use a single data converter. As an example of both of these variations, Figure 5 shows a non-interleaved analog-to-digital converter system **500** according to an embodiment of the present invention that avoids harmonic distortion products of degree n, where n is an integer greater than or equal to two, by confining an analog input signal to a specified frequency band spanning Fs/(2x(n+1)) to Fs/(n+1). If necessary to prevent aliasing, an optional anti-aliasing filter **505** filters the analog input signal to produce a filtered analog signal. A single ADC **510** sampling at a sample rate Fs, where Fs is any sampling frequency that is supported by the ADC, converts the filtered analog signal into a converted signal. A digital filter **535** having a pass-band that is substantially equivalent to the specified frequency band filters the converted signal to produce a digital output signal having reduced distortion products.

## Claims

1. A data converter system (100, 300, 400, 500) comprising:

  a data converter for converting an input signal into a converted signal; and
  a filter (135, 335, 435, 535) for filtering the converted signal to produce an output signal, the filter (135, 335, 435, 535) having a pass-band that is substantially equal to a specified frequency band;
  wherein the data converter is a single non-interleaved data converter, and the specified frequency band is a frequency band spanning Fs/(2x(n+1)) to Fs/(n+1), where Fs is the sample rate of the single non-interleaved data converter and n is an integer greater than or equal to two; or

wherein the data converter comprises a plurality of interleaved data converters for converting the input signal into a plurality of interleaved signals, and means for combining the plurality of interleaved signals into the converted signal and wherein the specified frequency band is a frequency band spanning Fs'/(2x(n+1)) to Fs'/(n+1), where Fs' is the effective sample rate of the plurality of interleaved data converters and n is an integer greater than or equal to two.

2. A data converter system as in claim 1, wherein:

each of the data converters (110, 115, 120, 125) comprises an analog-to-digital converter;
the input signal is an analog signal;
the converted signal and output signal are digital signals; and
the filter (135) comprises a digital filter.

3. A data converter system as in claim 1, wherein:

each of the data converters (310, 315, 320, 325) comprises an digital-to-analog converter;
the input signal is a digital signal;
the converted signal and output signal are analog signals; and
the filter (335) comprises an analog filter.

4. A data converter system as in claim 1, wherein:

each of the data converters ( 410, 415, 420, 425) comprises a track-and-hold;
the input signal is an analog signal;
the converted signal and output signal are analog signals; and
the filter (435) comprises an analog filter.

## Patentansprüche

1. Datenumsetzersystem (100, 300, 400, 500), umfassend:

einen Datenumsetzer zum Umwandeln eines Eingangssignals in ein umgewandeltes Signal; und
einen Filter (135, 335, 435, 535) zum Filtern des umgewandelten Signals, um ein Ausgangssignal zu erzeugen, wobei der Filter (135, 335, 435, 535) ein Durchlassband aufweist, das im Wesentlichen einem spezifizierten Frequenzband entspricht;
wobei der Datenumsetzer ein einzelner nicht-verschachtelter Datenumsetzer ist, und wobei das spezifizierte Frequenzband ein Frequenzband ist, das von Fs/(2x(n+1)) bis Fs/(n+1) reicht, wobei Fs die Abtastrate des einzelnen nicht-verschachtelten Datenumsetzers ist, und wobei n eine ganze Zahl größer oder gleich Zwei ist; oder
wobei der Datenumsetzer eine Mehrzahl verschachtelter Datenumsetzer zum Umwandeln des Eingangssignals in eine Mehrzahl verschachtelter Signale umfasst, und mit Mitteln zur Kombination der Mehrzahl von verschachtelten Signalen zu dem umgewandelten Signal, und wobei das spezifizierte Frequenzband ein Frequenzband ist, das von Fs'/(2x(n+1) bis Fs'/(n+1) reicht, wobei Fs' die effektive Abtastrate der Mehrzahl von verschachtelten Datenumsetzern ist, und wobei n eine ganze Zahl größer oder gleich Zwei ist.

2. Datenumsetzer nach Anspruch 1, wobei:

jeder der Datenumsetzer (110, 115, 120, 125) einen Analog-Digital-Umsetzer umfasst;
das Eingangssignal ein analoges Signal ist;
das umgewandelte Signal und das Ausgangssignal digitale Signale sind; und
der Filter (135) einen digitalen Filter umfasst.

3. Datenumsetzer nach Anspruch 1, wobei:

jeder der Datenumsetzer (310, 315, 320, 325) einen Digital-Analog-Umsetzer umfasst;
das Eingangssignal ein digitales Signal ist;

das umgewandelte Signal und das Ausgangssignal analoge Signale sind; und
der Filter (335) einen analogen Filter umfasst.

4. Datenumsetzer nach Anspruch 1, wobei:

jeder der Datenumsetzer (410, 415, 420, 425) ein Track-and-Hold-Glied umfasst;
das Eingangssignal ein analoges Signal ist;
das umgewandelte Signal und das Ausgangssignal analoge Signale sind; und
der Filter (435) einen digitalen Filter umfasst.

**Revendications**

1. Système convertisseur de données (100, 300, 400, 500) comprenant :

un convertisseur de données pour convertir un signal d'entrée en un signal converti ; et
un filtre (135, 335, 435, 535) pour filtrer le signal converti pour produire un signal de sortie, le filtre (135, 335, 435, 535) ayant une bande passante qui est sensiblement égale à une bande de fréquences spécifiée ;
le convertisseur de données étant un convertisseur de données non entrelacées unique, et la bande de fréquences spécifiée étant une bande de fréquences allant de $Fs/(2x(n+1))$ à $Fs/(n+1)$, où $Fs$ est la fréquence d'échantillonnage du convertisseur de données non entrelacées unique et $n$ est un entier supérieur ou égal à deux ; ou
le convertisseur de données comprenant une pluralité de convertisseurs de données entrelacées pour convertir le signal d'entrée en une pluralité de signaux entrelacés, et un moyen pour combiner la pluralité de signaux entrelacés dans le signal converti et la bande de fréquences spécifiée étant une bande de fréquences allant de $Fs'/(2x(n+1))$ à $Fs'/(n+1)$, où $Fs'$ est la fréquence d'échantillonnage efficace de la pluralité de convertisseurs de données entrelacées et $n$ est un entier supérieur ou égal à deux.

2. Système convertisseur de données selon la revendication 1 :

chacun des convertisseurs de données (110, 115, 120, 125) comprenant un convertisseur analogique-numérique ;
le signal d'entrée étant un signal analogique ;
le signal converti et le signal de sortie étant des signaux numériques ; et
le filtre (135) comprenant un filtre numérique.

3. Système convertisseur de données selon la revendication 1 :

chacun des convertisseurs de données (310, 315, 320, 325) comprenant un convertisseur numérique-analogique ;
le signal d'entrée étant un signal numérique ;
le signal converti et le signal de sortie étant des signaux analogiques ; et
le filtre (335) comprenant un filtre analogique.

4. Système convertisseur de données selon la revendication 1 :

chacun des convertisseurs de données (410, 415, 420, 425) comprenant un élément de suivi et maintien ;
le signal d'entrée étant un signal analogique ;
le signal converti et le signal de sortie étant des signaux analogiques ; et
le filtre (435) comprenant un filtre analogique.

Figure 1

**Figure 2**

Figure 3

**Figure 4**

**Figure 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7196650 B
- US 6473013 B
- EP 1336855 A2
- US 6744832 B
- US 6507624 B
- US 7483498 B
- US 20070081578 A1

### Non-patent literature cited in the description

- **YE. POBEREZHSKIY ; G. POBEREZHSKIY.** disclose sampling and signal reconstruction structures performing internal antialiasing filtering. *IEEE,* 2002
- **BRAD BRANNON.** Wideband Radios Need Wide Dynamic Range Converters. *Analog Dialogue,* 04 January 2002
- **BRAD BRANNON.** Using Wide Dynamic Range Converters for Wide Band Radios. *RF Design,* May 1995, vol. 18 (5